# EUROPÄISCHE PATENTANMELDUNG

(11) **EP 4 310 200 A2**
(43) Veröffentlichungstag der Anmeldung: **24.01.2024**
(21) Anmeldenummer: 23205888.3
(22) Anmeldetag: 16.09.2021
(51) Int. Cl.: C21D 7/10, C21D 7/13, B22F 5/00, B22F 7/04, B21D 22/02, B33Y 80/00, B33Y 40/20, B22F 10/66, B33Y 10/00, B22F 10/64, B22F 7/08, B21D 37/16, B22F 1/00, B22F 3/00, B22F 3/16, C21D 1/26, C21D 1/32, C21D 6/00, C21D 8/04, C21D 8/12, C21D 9/48

(54) **VERFAHREN ZUM HERSTELLEN UND DESIGN KOMPLEXER DREIDIMENSIONALER MAGNETISCHER ABSCHIRMELEMENTE, ABSCHIRMELEMENTE UND DEREN VERWENDUNG**

(30) Priorität: 16.09.2020 DE 102020124189
(62) Teilanmeldung aus: 21782652.8
(71) Anmelder: voestalpine Metal Forming GmbH, 3500 Krems an der Donau (AT); Mogema BV, 8084 GS Het Harde (NL)
(72) Erfinder: HOOGENBERG, Bas-Jan, 8043BP Zwolle (NL); VEHOF, Robert, 7425EJ Deventer (NL); BRADY, Brian, 3824BA Amersfoort (NL); DOMÍNGUEZ, Guillermo, 3826GD Amersfoort (NL); RADLMAYR, Karl, 4221 Steyregg (AT)
(74) Vertreter: HGF

(57) **Zusammenfassung**

Die Erfindung betrifft ein Verfahren zum Herstellen dreidimensionaler magnetischer Abschirmungen mit einer ausreichenden Permeabilität aus ungeglühten, weichgeglühten oder magnetisch geglühten weichmagnetischen Metallblechen, wobei das Metallblech entweder

in einem ein- oder mehrstufigen Prozess zu dem dreidimensionalen Bauteil kalt umgeformt wird, anschließend einer (magnetische) Glühung zur Erhöhung der Permeabilität unterzogen und dann in ein Formwerkzeug überführt wird, indem es im heißen Zustand oder auf Raumtemperatur in einem Werkzeug gehalten und/oder gepresst wird, welches die Sollkontur des Bauteils besitzt und durch das Werkzeug gegebenenfalls form-korrigiert oder kalibriert wird und, in dem Werkzeug abkühlen gelassen wird,
oder
ein Blech zum Zwecke der Umformung und der Erhöhung Permeabilität erhitzt wird und anschließend in einem Warmumformwerkzeug auf die Sollgeometrie umgeformt wird und gehalten wird und in dem Werkzeug abkühlen gelassen wird,
oder
das dreidimensionale Bauteil durch additive Fertigung erzeugt wird und anschließend einer (magnetischen) Glühung zur Erhöhung der Permeabilität unterzogen wird, sowie eine Abschirmvorrichtung.

## Beschreibung

Die Erfindung betrifft ein Verfahren zum Herstellen komplexer dreidimensionaler magnetischer Abschirmungen, Vorrichtungen zur magnetischen Abschirmung und deren Verwendung.

Materialien mit einer extrem hohen magnetischen Permeabilität, insbesondere Nickel-Eisen-Legierungen werden als magnetische Abschirmungen eingesetzt, da sie bei einer sehr hohen Permeabilität von µᵣ =50.000-140.000 den magnetischen Fluss insbesondere niedrig frequenter Magnetfelder konzentrieren. Derartige Materialien werden auch als weichmagnetische Materialien bezeichnet. Wenn derartige Metalle gebogen, verformt oder mechanisch bearbeitet werden, bricht allerdings die sehr hohe Permeabilität drastisch ein, wobei Werte bis µᵣ=150 möglich sind.

Dieser extreme Verlust an Permeabilität kann durch eine nachfolgende Wärmebehandlung wieder behoben werden, die Permeabilität kann sogar verbessert werden. Allerdings ist die Wärmebehandlungszeit relativ lang und die Temperatur recht hoch, was das Fließen des Materials begünstigen kann, was insbesondere bei verformten Materialien vollkommen unerwünscht ist. Deshalb werden solche Teile üblicherweise eingespannt und dann auf 1.000 - 1.400°C aufgeheizt.

Zur Erzeugung magnetischer Abschirmung ist es beispielsweise bekannt, Bleche aus einem solchen Material zu biegen, wie es auch in der US 43331285 offenbart wird. Darüber hinaus ist es bekannt, derartige Materialien mit Wasserstrahl oder Laser zu schneiden oder sie tieferzuziehen (JP 11186019 A).

Aus der US 6813364 B1 ist ein einfaches Tiefziehverfahren für kleine Teile bekannt.

Aus der WO2014/090282 A1 ist ein Elektroabscheideverfahren bekannt.

Aus der CA 2080177 C ist ein Spritzpressverfahren für kleine Teile bekannt.

Darüber hinaus ist es auch bekannt, komplexe Bauteile durch das Fräsen aus dem vollen Material herzustellen.

Aufgabe der Erfindung ist es, ein Verfahren zu schaffen, mit dem komplexe dreidimensionale magnetische Abschirmvorrichtungen auf einfache, kostengünstige Art und Weise erzeugt werden können.

Die Aufgabe wird mit einem Verfahren mit den Merkmalen des Anspruchs 1 gelöst.

Vorteilhafte Weiterbildungen sind in den hiervon abhängigen Unteransprüchen gekennzeichnet.

Es ist eine weitere Aufgabe, eine magnetische Abschirmvorrichtung zu schaffen, welche kostengünstig komplex dreidimensional ausgebildet ist.

Die Aufgabe wird mit den Merkmalen des Anspruch 22 gelöst.

Vorteilhafte Weiterbildungen sind in den hiervon abhängigen Unteransprüchen gekennzeichnet.

Die Erfinder haben herausgefunden, dass einerseits im Bereich High Tech (u. a. der Halbleitertechnik, Elektronenmikroskopie) und andererseits im Bereich der automotiven Anwendungen, insbesondere durch den Trend zu Elektrofahrzeugen kombiniert mit dem autonomen Fahren, mechatronische Systeme mit einer sehr hohen Präzision und Genauigkeit und andererseits hohe Stromleistungen mehr und mehr verlangt werden, was einen höheren Anteil an magnetischen Abschirmvorrichtungen bedingt.

Problematisch ist jedoch, dass, wie bereits ausgeführt, sehr große dreidimensionale Objekte sich aus diesen Materialien nicht fertigen lassen, da insbesondere die hohe Temperatur bei der Glühung von 1.000 - 1.400°C einerseits, andererseits relativ große Oberflächen und gegebenenfalls auch geringe Dicken sich derzeit kaum darstellen lassen. Grund hierfür ist, dass derartige große Bauteile schon alleine aufgrund der Größe bei den genannten Temperaturen kriechen und sich verformen. Entsprechende Vorrichtungen zum Vermeiden vom Kriechen, welche die Bauteile an unterschiedlichen Punkten stützen könnten sind sehr komplex und sehr teuer. Zudem hat sich herausgestellt, dass auch mit solchen Vorrichtungen eine Verformung komplexer Bauteile nicht sicher ausgeschlossen werden kann.

Erfindungsgemäß sieht das Verfahren zwei mögliche Verfahrensrouten vor, um komplexe dreidimensionale magnetische Abschirmvorrichtungen zu schaffen.

Eine erste Verfahrensroute sieht vor, aus den entsprechenden Materialien in einem kalten Tiefziehprozess das komplexe dreidimensional geformte Teil herzustellen. Dieses komplexe dreidimensionale Teil wird anschließend im Vakuum oder unter Wasserstoffatmosphäre geglüht und anschließend in heißem Zustand in ein Werkzeug eingelegt, welches der Sollform bzw. Sollgeometrie des fertigen Bauteils entspricht und dort so lange gehalten wird, bis es Kriechstabil ist und entnommen werden kann.

In diesem zweiten Schritt des Formprozesses wird somit die Formabweichung durch Kriechen des Materials während des Glühprozesses korrigiert. Erfindungsgemäß wird das Material hierbei nicht abgeschreckt, sondern das Formteil im Formwerkzeug in seiner Form gehalten und gepresst. Im Formwerkzeug kann es nun abkühlen, wobei gegebenenfalls das Formwerkzeug vorgeheizt ist, um die optimale Abkühlrate einzustellen.

Es ist von Vorteil, dass die Teile die absolut korrekte Form haben, also der Sollgeometrie entsprechen, auch wenn diese komplex dreidimensional ist, da Deformationen durch Kriechen des Werkstoffs in diesem Schritt nicht auftreten können. Da die gegebenenfalls stattfindende Formkorrektur, Kalibrierung oder Umformung noch bei sehr hohen Temperaturen stattfindet, können die magnetischen Eigenschaften weitgehend erhalten bleiben.

In einer Abwandlung des Verfahrens können geeignete Bauteile, insbesondere wenn der Werkstoff keinen sehr hohen Umformwiderstand besitzt, nach dem magnetischen Glühen abkühlen gelassen und bei einer geeigneten Temperatur, zum Beispiel Raumtemperatur in das Werkzeug eingelegt und kalibriert werden. Um negative Einflüsse auf die Permeabilität zu verringern kann gegebenenfalls die Umformgeschwindigkeit angepasst werden und insbesondere ein schlagartiges Umformen vermieden werden und statt dessen ein langsameres "in Form drücken" erfolgen.

Die zweite Lösung sieht vor, ein Stahlblech oder insbesondere eine unter Vakuum oder Wasserstoffatmosphäre zum Zwecke der Einstellung der Permeabilität geglühte Stahlplatte aus dem weichmagnetischen Material, in heißem Zustand in ein Presswerkzeug einzulegen, in dem das Teil in einem Schritt umgeformt wird und in dem umgeformten Zustand gehalten wird und in der Form abkühlt, wobei gegebenenfalls die Form vorgeheizt wird, um die Abkühlgeschwindigkeit zu verringern.

In beiden Fällen kann das Werkzeug vorgewärmt werden oder während des Abkühlens so beheizt werden, dass die Abkühlrate an die Anforderung des weichmagnetischen Materials angepasst ist.

Bei der Erfindung ist von Vorteil, dass durch das definierte Halten und Abkühlen in einem Werkzeug, welches so geformt ist, dass es dem Endbauteil entspricht und durch das Einstellen von Abkühlbedingungen, die eine optimale magnetische Permeabilität zulassen, Kriechneigungen des Materials entgegengewirkt werden kann und das Material formbeständig und formentreu mit hoher Permeabilität herstellbar ist. Während des magnetischen Glühens eingetretene Formänderungen eines kalt fertig geformten Materials können in dem Werkzeug korrigiert werden, ohne dass die magnetischen Eigenschaften zu stark (d.h. im Bereich von Faktor 10 und größer) verschlechtert werden.

Die Erfindung betrifft somit ein Verfahren zum Herstellen dreidimensionaler magnetischer Abschirmungen mit einer ausreichenden Permeabilität aus ungeglühten, weichgeglühten oder magnetisch geglühten weichmagnetischen Metallblechen, wobei das Metallblech entweder
in einem ein- oder mehrstufigen Prozess zu dem dreidimensionalen Bauteil kalt umgeformt wird, anschließend einer (magnetischen) Glühung zur Erhöhung der Permeabilität unterzogen und dann in ein Formwerkzeug überführt wird, indem es im heißen Zustand oder auf Raumtemperatur in einem Werkzeug gehalten und/oder gepresst wird, welches die Sollkontur des Bauteils besitzt und durch das Werkzeug gegebenenfalls formkorrigiert oder kalibriert wird und, in dem Werkzeug abkühlen gelassen wird,
   oder
ein Blech zum Zwecke der Umformung und der Erhöhung Permeabilität erhitzt wird und anschließend in einem Warmumformwerkzeug auf die Sollgeometrie umgeformt wird und gehalten wird und in dem Werkzeug abkühlen gelassen wird,
   oder
das dreidimensionale Bauteil durch additive Fertigung erzeugt wird und anschließend einer (magnetischen) Glühung zur Erhöhung der Permeabilität unterzogen wird.

Eine Ausführungsform sieht vor, dass als weichmagnetisches Metallblech Blech aus einer aus einer magnetisierbaren Nickel-Eisen-Legierung, einer magnetisierbaren Silizium-Eisen-Legierung, einer magnetisierbaren Kobalt-Eisen-Legierung oder anderen magnetisierbaren Metalllegierungen verwendet wird.

Eine Ausführungsform sieht vor, dass das Blech vor der kalten Umformung oder nach der kalten Umformung oder das Blech vor der warmen Umformung einer Weichglühung unterzogen wird.

Eine Ausführungsform sieht vor, dass bei einer Nickel-Eisen-Legierung das Weichglühen bei 600 bis 900°C, insbesondere bis 700 bis 800°C durchgeführt wird.

Eine Ausführungsform sieht vor, dass bei einer Nickel-Eisen-Legierung das magnetische Glühen bei 1000 bis 1400°C, insbesondere 1100 bis 1300°C, insbesondere bei 1150°C durchgeführt wird.

Eine Ausführungsform sieht vor, dass bei einer Nickel-Eisen-Legierung die Warmumformung bei 500 bis 800°C, insbesondere 600 bis 800°C, bevorzugt 600°C durchgeführt wird.

Eine Ausführungsform sieht vor, dass bei einer Nickel-Eisen-Legierung das Warmkalibrieren bei 500 bis 800°C, insbesondere 600 bis 800°C, bevorzugt 600°C durchgeführt wird.

Eine Ausführungsform sieht vor, dass bei einer Kobalt-Eisen-Legierung das magnetische Glühen bei 700 bis 950°C, insbesondere 730 bis 900°C durchgeführt wird.

Eine Ausführungsform sieht vor, dass bei einer Kobalt-Eisen-Legierung die Warmumformung bei 500 bis 800°C, insbesondere 600 bis 800°C, durchgeführt wird.

Eine Ausführungsform sieht vor, dass bei einer Kobalt-Eisen-Legierung das Warmkalibrieren bei 500 bis 800°C, insbesondere 600 bis 800°C, durchgeführt wird.

Eine Ausführungsform sieht vor, dass bei einer Silizium-Eisen-Legierung das Weichglühen bei 600 bis 950°C, insbesondere bis 700 bis 800°C durchgeführt wird.

Eine Ausführungsform sieht vor, dass bei einer Silizium-Eisen-Legierung das magnetische Glühen bei 700 bis 1100°C, insbesondere 750 bis 1050°C durchgeführt wird.

Eine Ausführungsform sieht vor, dass bei einer Silizium-Eisen-Legierung, die Warmumformung bei 500 bis 800°C, insbesondere 600 bis 800°C durchgeführt wird.

Eine Ausführungsform sieht vor, dass bei einer Silizium-Eisen-Legierung das Warmkalibrieren bei 500 bis 800°C, insbesondere 600 bis 800°C durchgeführt wird.

Eine Ausführungsform sieht vor, dass die Zykluszeit bei Nickel-Eisen-Legierungen bei einem Weichglühen 2 bis 10h beträgt.

Eine Ausführungsform sieht vor, dass die Zykluszeit bei Nickel-Eisen-Legierungen bei einem magnetischen Glühen 2 bis 150h beträgt.

Eine Ausführungsform sieht vor, dass die Zykluszeit bei Nickel-Eisen-Legierungen bei einem Warmumformen 1 sek. bis 2h beträgt.

Eine Ausführungsform sieht vor, dass die Zykluszeit bei Nickel-Eisen-Legierungen bei einem Warmkalibrieren 1 sek. bis 2h beträgt.

Eine Ausführungsform sieht vor, dass Zykluszeit bei Nickel-Eisen-Legierungen bei einem Kaltumformen 1 sek. bis 2h beträgt.

Eine Ausführungsform sieht vor, dass die Zykluszeit bei Nickel-Eisen-Legierungen bei einem Kaltkalibrieren 1 sek. bis 2h beträgt.

Eine Ausführungsform sieht vor, dass die Zykluszeit bei Kobalt-Eisen-Legierungen bei einem magnetischen Glühen 2 bis 150h beträgt.

Eine Ausführungsform sieht vor, dass die Zykluszeit bei Kobalt-Eisen-Legierungen bei einem Warmumformen 1 sek. bis 2h beträgt.

Eine Ausführungsform sieht vor, dass die Zykluszeit bei Kobalt-Eisen-Legierungen bei einem Warmkalibrieren 1 sek. bis 2h beträgt.

Eine Ausführungsform sieht vor, dass die Zykluszeit bei Kobalt-Eisen-Legierungen bei einem Kaltumformen 1 sek. bis 2h beträgt.

Eine Ausführungsform sieht vor, dass die Zykluszeit bei Kobalt-Eisen-Legierungen bei einem Kaltkalibrieren 1 sek. bis 2h beträgt.

Eine Ausführungsform sieht vor, dass die Zykluszeit bei Silizium-Eisen-Legierungen bei einem Weichglühen 0,25 bis 10h beträgt.

Eine Ausführungsform sieht vor, dass die Zykluszeit bei Silizium-Eisen-Legierungen bei einem magnetischen Glühen 0,5 bis 10h beträgt.

Eine Ausführungsform sieht vor, dass die Zykluszeit bei Silizium-Eisen-Legierungen bei einem Warmumformen 1 sek. bis 2h beträgt.

Eine Ausführungsform sieht vor, dass die Zykluszeit bei Silizium-Eisen-Legierungen bei einem Warmkalibrieren 1 sek. bis 2h beträgt.

Eine Ausführungsform sieht vor, dass die Zykluszeit bei Silizium-Eisen-Legierungen bei einem Kaltumformen 1 sek. bis 2h beträgt.

Eine Ausführungsform sieht vor, dass die Zykluszeit bei Silizium-Eisen-Legierungen bei einem Kaltkalibrieren 1 sek. bis 2h beträgt.

Eine Ausführungsform sieht vor, dass die Umformgeschwindigkeit, insbesondere beim Warmumformen bevorzugt zwischen 5 mm/min und 60 mm/min Werkzeuggeschwindigkeit beträgt.

Eine Ausführungsform sieht vor, dass das Bauteil nach dem Warmumformen oder nach dem Halten im Werkzeug bei einer Temperatur entnommen wird, bei der das Bauteil gegen Materialfließen stabil ist und an Luft abkühlen kann und insbesondere bei 200 bis 600°C, insbesondere 300 bis 500°C entnommen wird.

Eine Ausführungsform sieht vor, dass das Blech mittels Schweißungen aus mehreren Platinen hergestellt wird, insbesondere Kombinationen von mehreren Platinen aus verschieden Legierungen, Dicken oder Anlassgraden oder Glühgraden, insbesondere bezüglich eines Weich-, Lösungs- und/oder Spannungsarmglühen.

Eine Ausführungsform sieht vor, dass die geschweißten Platinen eben oder dreidimensional ausgeformte Bauteile sind, die vor, innerhalb oder nach dem Prozess miteinander verschweißt werden.

Ein weiterer Aspekt der Erfindung betrifft eine Abschirmvorrichtung aus einem dreidimensionalen ausgebildeten Metallblech einer hohen Permeabilität oder zusammengesetzt aus einer Mehrzahl von Metallblechen, insbesondere hergestellt nach einem Verfahren nach einem der vorhergehenden Ansprüche, wobei das Metallblech entweder
in einem ein- oder mehrstufigen Prozess zu dem dreidimensionalen Bauteil kalt umgeformt ist, anschließend einer (magnetischen) Glühung zur Erhöhung der Permeabilität unterzogen und dann in ein Formwerkzeug überführt wird, indem es im heißen Zustand oder auf Raumtemperatur in einem Werkzeug gehalten und/oder gepresst ist, welches die Sollkontur des Bauteils besitzt und durch das Werkzeug gegebenenfalls formkorrigiert oder kalibriert wird und, in dem Werkzeug abkühlen gelassen wird,
   oder
ein Blech zum Zwecke der Umformung und der Erhöhung Permeabilität erhitzt ist und anschließend in einem Warmumformwerkzeug auf die Sollgeometrie umgeformt ist und gehalten wird und in dem Werkzeug abkühlen gelassen ist,
   oder
das dreidimensionale Bauteil durch additive Fertigung erzeugt ist und anschließend einer (magnetischen) Glühung zur Erhöhung der Permeabilität unterzogen ist..

Eine Ausführungsform sieht vor, dass das Metallblech aus einer magnetisierbaren Nickel-Eisen-Legierung, einer magnetisierbaren Silizium-Eisen-Legierung, einer magnetisierbaren Kobalt-Eisen-Legierung oder anderen magnetisierbaren Metalllegierungen besteht.

Eine Ausführungsform sieht vor, dass bei Nickel-Eisen-Legierungen der Nickel-Gehalt zwischen 30 und 90 Gew.-% beträgt, wobei der Nickel Gehalt insbesondere zwischen 50-80 Gew.-% beträgt, wobei die Nickel-Eisen-Legierung weitere Elemente wie Molybdän und/oder Chrom im Bereich von bis zu 10 Gew.-% umfassen kann und weitere Elemente wie Mangan, Silizium und/oder Kohlenstoff im Bereich von jeweils bis zu 1 Gew.-% umfassen kann und der Rest aus Eisen und unvermeidbare Verunreinigungen besteht..

Eine Ausführungsform sieht vor, dass bei einer Silizium-Eisen-Legierungen der Silizium-Gehalt zwischen 0,1-8 Gew.-% beträgt wobei die Silizium-Eisen-Legierung Mangan bis zu 1 Gew.-% und Aluminium bis 2 Gew.-% enthalten kann und der Rest aus Eisen und unvermeidbare Verunreinigungen besteht.

Eine Ausführungsform sieht vor, dass Bei Kobalt-Eisen-Legierungen der Kobalt-Gehalt 9-60 Gew.-% bevorzugt 10-27 Gew.-% beträgt, wobei die Kobalt-Eisen-Legierung Chrom von 2 bis 10 Gew.-% enthalten kann und Molybdän, Vanadium, Niob, Tantal, Aluminium, Zirkonium und/oder Mangan im Bereich von jeweils bis zu 2 Gew.-% und in Summe bis zu 5 Gew.-% enthalten sein können und der Rest aus Eisen und unvermeidbaren Verunreinigungen besteht.

Ein weiterer Aspekt der Erfindung betrifft die Verwendung einer Abschirmvorrichtung wie zuvor beschrieben für Verkleidungen, Auskleidungen und Abschirmungen aus einzelnen Blechen oder komplexen Abschirmbauteilen aus mehreren zusammengesetzten Blechen.

Ein weiterer Aspekt der Erfindung betrifft die Verwendung einer Abschirmvorrichtung wie zuvor beschrieben für die Ausbildung von Gehäusen, Kammern, Räumen und dergleichen.

Die Erfindung wird anhand einer Zeichnung beispielhaft erläutert, es zeigen dabei:
- Figur 1:: Verschiedene Verfahrensabläufe von Ausführungsformen mit separatem Form- und Kalibrierschritt für Nickel-Eisen-Legierungen;
- Figur 2:: Verschiedene Verfahrensabläufe von Ausführungsformen mit einzelnen Formschritten für Nickel-Eisen-Legierungen;
- Figur 3:: Verschiedene Verfahrensabläufe von Ausführungsformen mit separatem Form- und Kalibrierschritt für Kobalt-Eisen-Legierungen;
- Figur 4:: Verschiedene Verfahrensabläufe von Ausführungsformen mit einzelnen Formschritten für Kobalt-Eisen-Legierungen;
- Figur 5:: Verschiedene Verfahrensabläufe von Ausführungsformen mit separatem Form- und Kalibrierschritt für Silizium-Eisen-Legierungen;
- Figur 6:: Verschiedene Verfahrensabläufe von Ausführungsformen ohne Weichglühschritt für Silizium-Eisen-Legierungen;
- Figur 7: Verschiedene Verfahrensabläufe von Ausführungsformen mit einzelnen Formschritten für Silizium-Eisen-Legierungen;

Die Erfindung betrifft die komplexe 3D-Formung von Metallblechen aus beispielsweise Nickel-Eisen-Legierungen, welche weichmagnetische Eigenschaften haben. Diese Werkstoffe benötigen an sich eine komplexe und kostspielige Verarbeitung aufgrund einer benötigten Wärmebehandlung am Ende des Verfahrens unter kontrollierten Bedingungen. Diese Wärmebehandlung optimiert die magnetischen Eigenschaften, welche weitestgehend verlorengehen, wenn das Material nach der Wärmebehandlung umgeformt wird.

Erfindungsgemäß wird ein Verfahren geschaffen, welches zu existierenden Verfahrensrouten zusätzliche Verfahrensschritte hinzufügt, welche eine geänderte Verfahrensweise zulassen und so einerseits den Prozess erheblich effektiver machen und insbesondere einen abschließenden Wärmebehandlungsschritt nach einer nötigen Umformung entbehrlich machen.

Die erfindungsgemäß verwendeten weichmagnetischen Materialien werden durch eine hohe magnetische Permeabilität gekennzeichnet. Die Gruppe der Materialien umfasst hierbei nicht nur Nickel-Eisen-Legierungen, sondern auch Silizium-Eisen-Legierungen, Kobalt-Eisen-Legierungen und weitere.

Alle Prozentangaben sind -soweit nicht anders angegeben- in Gewichtsprozent (Gew.-%) gemeint und zu interpretieren.

Bei Nickel-Eisen-Legierungen beträgt der Nickel-Gehalt 30-90 Gew.-%. Derartige Materialien entwickeln eine außergewöhnlich hohe magnetische Permeabilität von µᵣ ≥ 1000, wodurch sie es erlauben, hohe Dichte von Magnetfluss des Materials zuzulassen. Obwohl die ursprüngliche Permeabilität sehr hoch ist, kann sie noch weiter erhöht werden durch die schon genannte Wärmebehandlung. Oberhalb von 30 Gew.-% Nickel unterliegt die Nickel-Eisen-Legierung einer Phasenumwandlung von BCC zu FCC. Der FCC für das Material ist bis zum Schmelzpunkt stabil, was sehr hohe Wärmebehandlungstemperaturen erlaubt. Die Curie-Temperatur reicht von 200°C bei 35 Gew.-% Nickel bis höchstens 600°C bei etwa 70 Gew.-% Nickel. Bevorzugt kann der Nickel Gehalt zwischen 50-80 Gew.-% betragen. Die Nickel-Eisen-Legierung kann weitere Elemente wie Molybdän und/oder Chrom im Bereich von bis zu 10% umfassen. Die Nickel-Eisen-Legierung kann weitere Elemente wie Mangan, Silizium und/oder Kohlenstoff im Bereich von jeweils bis zu 1% umfassen.

Das Weichglühen kann in einem Temperaturbereich von 600 - 900°C mit einer Zykluszeit von 1-10h erfolgen, die magnetische Glühung kann in einem Temperaturbereich von 1000 - 1400°C stattfinden, mit einer Zykluszeit von 0,5 - 150h.

Zykluszeit oder Behandlungszeit im Sinne der Erfindung ist die gesamte Zeit, in welcher das Material wärmebehandelt wird, d.h. die Aufheizzeit und Abkühlzeit ist inkludiert. Die Zykluszeit kann sich vorzugsweise an der Dicke des Materials orientieren, d.h. bei dünnen Blechen von 0,1 mm wird das untere Limit der Zykluszeit vorzugsweise angewandt, während bei dickeren Blechen > 5 mm Dicke in Richtung des oberen Limits gearbeitet werden kann.

Für Silizium-Eisen-Legierungen beträgt der Silizium-Gehalt typischerweise von 0,1-8 Gew.-%. Bei einem Silizium-Gehalt oberhalb von 2 Gew.-% liegt ausschließlich die BCC-Phase bis zum Schmelzpunkt vor, welches auch hier eine hohe Temperaturbehandlung erlaubt. Die Curie-Temperatur reicht von 660°C bei 8 Gew.-% Silizium bis höchstens 770°C bei Abwesenheit von Silizium. Die Silizium-Eisen-Legierungen kann Mangan bis zu 1 % und Aluminium bis 2 % enthalten.

Die Weichglühung kann diesen Legierungen vorzugsweise im Temperaturbereich von 550 - 750 °C stattfinden. Die Zykluszeit kann zwischen 10min und 10 h betragen.

Die optionale Weichglühung kann bei bestimmten Legierungen eine weitere Verbesserung des Umformverhaltens sicherstellen. Eine Kaltumformung als erster Verarbeitungsschritt bei den Güten mit niedrigerem Si-Gehalt, bevorzugt unter 1,5 % eine Warmumformung bei den hoch legierten Si-Legierungen bevorzugt über 1,5 % Si kann dem Weichglühen vorzuziehen um ein gutes Umformverhalten sicherzustellen sein. Die Magnetische Glühung kann im Temperaturbereich von 750 - 1050°C stattfinden, die Zykluszeit beträgt vorzugsweise 5sec bis 10h. In einem kontinuierlichen Glühverfahren kann die Zykluszeit auf 5 sek. bis 30 sek. eingestellt werden, welches die Herstellzeit verringern kann. Bei einem Haubenglühverfahren kann die Zykluszeit zwischen 1h und 10h betragen.

Bei Kobalt-Eisen-Legierungen beträgt der Kobalt-Gehalt 9-60 Gew.-% bevorzugt 10-27 Gew.-%. Charakteristisch für diese Legierungen ist eine hohe magnetische Sättigung von bis zu 2.4 T. Obwohl der Permeabilität die Nickel-Eisen-Legierungen nicht übertrifft (weniger als etwa 20.000 µ) ist es wegen der hohen Sättigung eine bevorzugte Wahl zur Erreichung einer hohen Flussdichte bei magnetischen Abschirmungen oder sonstige Flussleiter (z.B. Aktuatoren). Die Curie-Temperatur reicht von 850°C bei 9 Gew.-% Kobalt bis höchstens 980°C bei etwa 40 Gew.-% Kobalt. Bei etwa 900-950°C unterliegt die Kobalt-Eisen-Legierung einer Phasenumwandlung von BCC (Ferrit) zu FCC (Austenit), daher sollte die Wärmebehandlung bevorzugt bei Temperaturen unterhalb von 900°C stattfinden. Außerdem bildet sich bei einer Konzentration von 50/50 Gew.-% Kobalt-Eisen bei einer Temperatur unter 730°C ein Phasenumwandlung zu einem sogenannten B2-Superlattice wobei die Sprödigkeit stark zunimmt. Deswegen liegt die gewünschte Temperatur für komplexe Formoperationen zwischen diesen beiden Phasenumwandlungen. Die Kobalt-Eisen-Legierung kann weitere Elemente wie Chrom enthalten. Chrom erhöht den Korrosionschutz und wird vorzugsweise im Bereich von 2 bis 10 % zulegiert. Weitere Elemente wie Molybdän, Vanadium, Niob, Tantal, Aluminium, Zirkonium und/oder Mangan können im Bereich von jeweils bis zu 2 % und in Summe bis zu 5% zulegiert werden.

Materialien, die in der Lage sind, Magnetflusslinien aufzunehmen und zu führen, werden benötigt, wenn magnetische Felder abgeschirmt werden sollen. Dies betrifft zum Beispiel Präzisionssensorinstrumente, bei denen magnetische Felder parasitische Effekte bilden könnten. Beispiele sind wissenschaftliche Anwendungen (Elektronenmikroskope, Atomkraftmikroskope usw.), medizinische Geräte, der Bereich der Energie, Halbleiter (Subnanometer, Präzisionsmechatronik) und andere. Zusätzlich kann abgesehen werden, dass der Übergang zu elektrisch angetriebenen Fahrzeugen und der Übergang zum autonomen Fahren viel stärkere magnetische Abschirmungen in Art und Umfang benötigt, da die hohen Spannungen in Gleichstrommotoren die Elektronik negativ beeinflusst, welche insbesondere umgebenden Verkehr analysiert.

Wie bereits ausgeführt, werden derartige Materialien üblicherweise mit einer Schlussglühung in einen erneut sehr hohen weichmagnetischen Zustand mit einer sehr hohen magnetischen Permeabilität gebracht, was jedoch dazu führt, dass komplexe Formen nicht herstellbar sind.

Erfindungsgemäß wird eine Wärmebehandlung vorgesehen, bei der bei eine Nickel-Eisen-Legierung für eine bestimmte Zeit aufgeheizt wird, auf typischerweise 700°C - 800°C. Diese Temperatur ist für das jeweilige Material oberhalb der sogenannten Rekristallisationstemperatur. Dieses Rekristallisationsglühen wird üblicherweise für 0,5 bis 10 Stunden durchgeführt und das Ergebnis ist eine Materialerweichung und eine erhöhte Duktilität (mit Ausnahme der Kobalt-Legierung), um das Material für nachfolgende Verfahren vorzubereiten. Im Folgenden wird dieser Prozess als Weichglühen bezeichnet.

Zudem ist eine Hochtemperaturwärmebehandlung bei der Verwendung von Nickel-Eisen-Legierungen vorgesehen, welche ebenfalls das Material für eine bestimmte Zeitperiode aufheizt, wobei der Temperaturbereich von 1000°C - 1400°C, insbesondere 1050°C für eine Zeit von 1 bis 6 Stunden gehalten wird. Während dieser Behandlungszeit wachsen die Kristalle im Material zu einer Größe heran, mit der sie sogar für das Auge ohne Weiteres sichtbar sind. Dieser Prozess verbessert die Abschirmeigenschaften erheblich durch die Erhöhung der Permeabilität (µ) sogar bis zum Faktor 10 oder mehr. Vorzugsweise wird dieses Aufheizen im Vakuum oder in Wasserstoffatmosphäre durchgeführt, wobei die beiden Verfahren im Vakuum oder in Wasserstoffatmosphäre dazu dienen, Unreinheiten zu eliminieren. Das Entfernen von Verunreinigungen wiederum erlaubt ein größeres bzw. weiteres Kornwachstum. Im Folgenden wird dieser Prozess als Magnetisierungsglühen bezeichnet. Im Allgemeinen kann die Zykluszeit der ersten Weichglühung vorzugsweise schneller durchlaufen werden, also kürzer sein, als jene der allfällig folgenden Magnetisierungsglühung. Dies kann die Gefügebildung unterstützen.

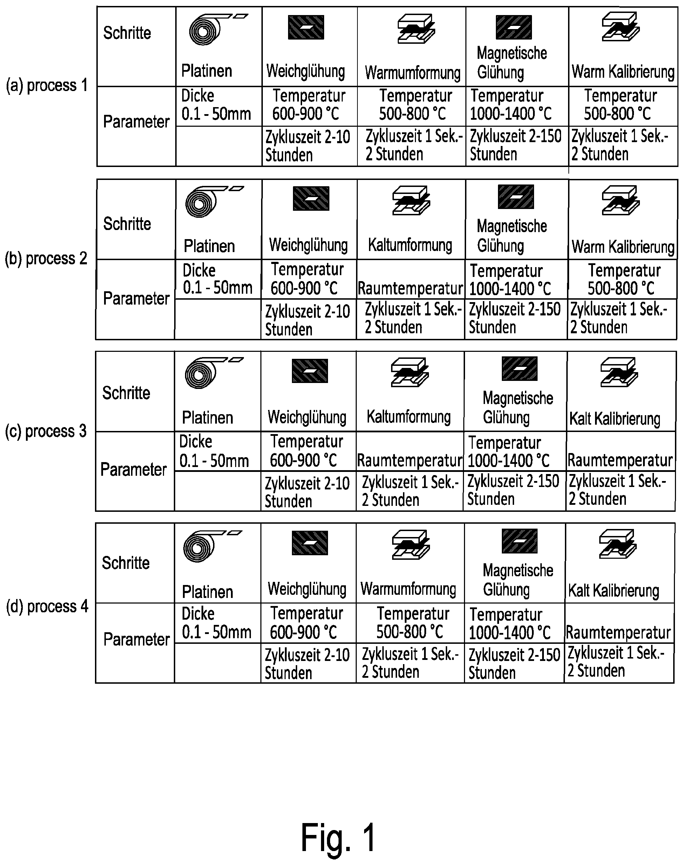

In Figur 1(a) ist ein möglicher Verfahrensablauf für Nickel-Eisen-Legierungen gezeigt. Ein Blech aus einer Legierung mit weichmagnetisch einstellbaren Eigenschaften, wie einer Nickel-Basis-Legierung in einer Stärke von 0,1 bis 50mm wird zunächst einer Weichglühung unterzogen.

Anschließend erfolgt eine Umformung entweder im kalten oder warmen Zustand. Bei einer kalten Umformung (beispielsweise gezeigt in Fig. 1 (b)) erfolgt diese in einem ein- oder mehrstufigen Prozess bis zum fertigen Bauteil. Im warmen Zustand erfolgt eine einstufige Umformung bei Temperaturen von 500 bis 800°C.

Für die Warmumformung kann die Hitze aus der Weichglühung genutzt werden, oder eine erneute Aufheizung erfolgen.

Anschließend erfolgt für beide möglichen Verfahrensrouten das magnetische Glühen, mit dem die Permeabilität eingestellt wird. Diese erfolgt bei 1000 bis 1400°C für 1 bis 6 Stunden. Anschließend wird der so erhaltene Formkörper bei 500 bis 800°C einer Warmkalibrierung bzw. Formkorrektur oder einer Formstabilisierung im warmen Zustand in einem hierfür geeigneten Werkzeug unterworfen. Um den Herstellungsaufwand zu vereinfachen und ein robustes Verfahren sicherzustellen kann die Kalibrierung auch im kalten Zustand erfolgen. Dies zeigen die Figuren 1 (c) and 1 (d).

Das bedeutet, dass die Formkörper, die sich ggf. durch die Magnetisierungs-Wärmebehandlung verzogen haben oder bei denen das Material durch den Wärmeeinfluss oder das Eigengewicht im warmen Zustand gekrochen ist, wieder in die Sollgeometrie gebracht werden. Hierzu besitzt das Werkzeug die entsprechende Geometrie, die der Sollgeometrie des geformten Bauteiles entspricht. Somit wird keine komplette Umformung sondern eine Formanpassung oder Kalibrierung durchgeführt. Hierzu kann selbstverständlich auch die Wärme des Bauteils aus dem Magnetisierungsglühen verwendet werden. Insbesondere kann die Abkühlgeschwindigkeit so eingestellt werden, dass die Abkühlkurve so verläuft, dass eine maximale Permeabilität erhalten bleibt.

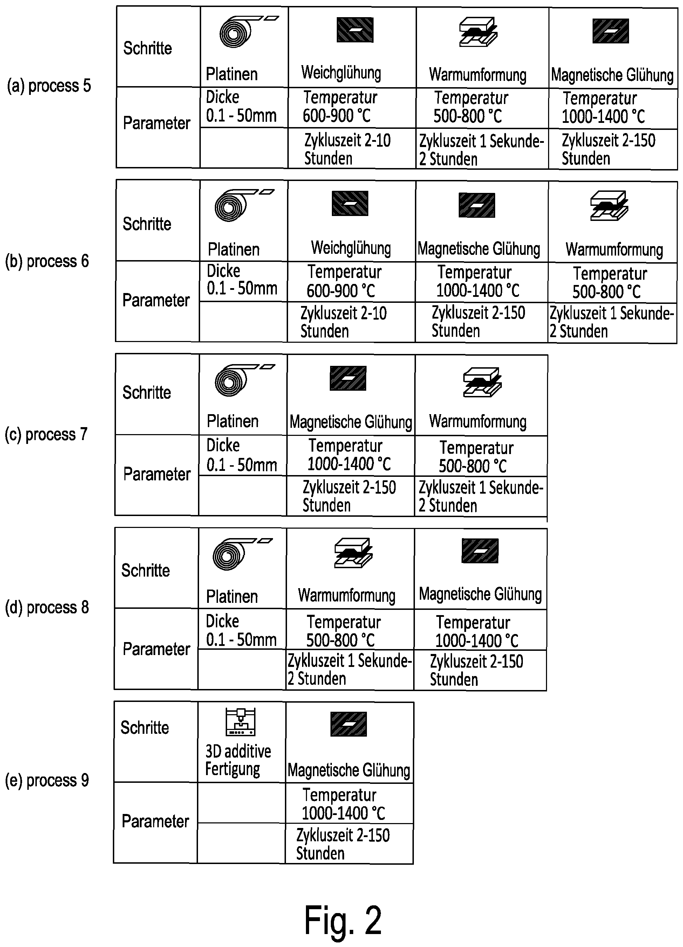

Bei einer weiteren vorteilhaften Ausführungsform des Verfahrens (Figur 2(a)) entfällt der erste Formgebungsschritt, hier erfolgt direkt nach dem Weichglühen das Magnetisierungsglühen, wobei insbesondere unter Nutzung der Wärme aus dem Magnetisierungsglühen ein abschließender Formgebungsschritt erfolgt. Dieser ist vorzugsweise so ausgestaltet, dass die Blechplatine in einem Schritt warm umgeformt wird und dann im Werkzeug gehalten und abkühlen gelassen wird, zumindest bis zur mechanischen Stabilität und so lange, wie die Abkühlgeschwindigkeit zur Beibehaltung der Permeabilität notwendig ist.

Bei einer weiteren vorteilhaften Ausführungsform (Figur 2(b)), wird die Platine direkt dem Magnetisierungsglühen unterworfen, so dass das Weichglühen in diesem Schritt integriert ist. Die abschließenden Formgebung entspricht dann der zuvor beschriebenen Ausführungsform.

Nach all den genannten Schritten können Schneid-, Fräs-, Bohr-, Schweiß-, Oberflächen- und Reinigungsschritte folgen, darüber hinaus können auf aus Blech gefertigten Bauteilen weitere Schichten oder Volumina, beispielsweise mit 3D-Druck additiv aufgebracht werden.

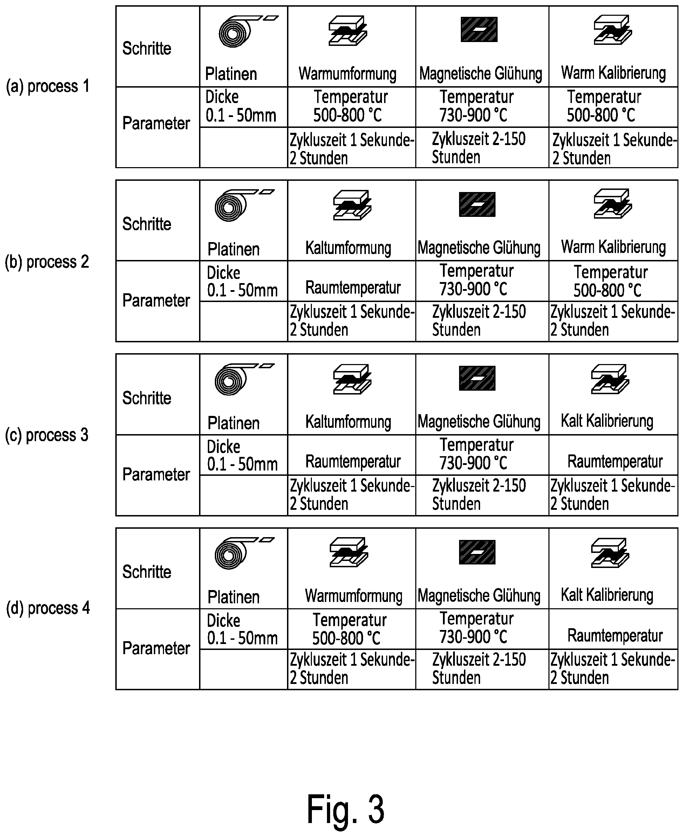

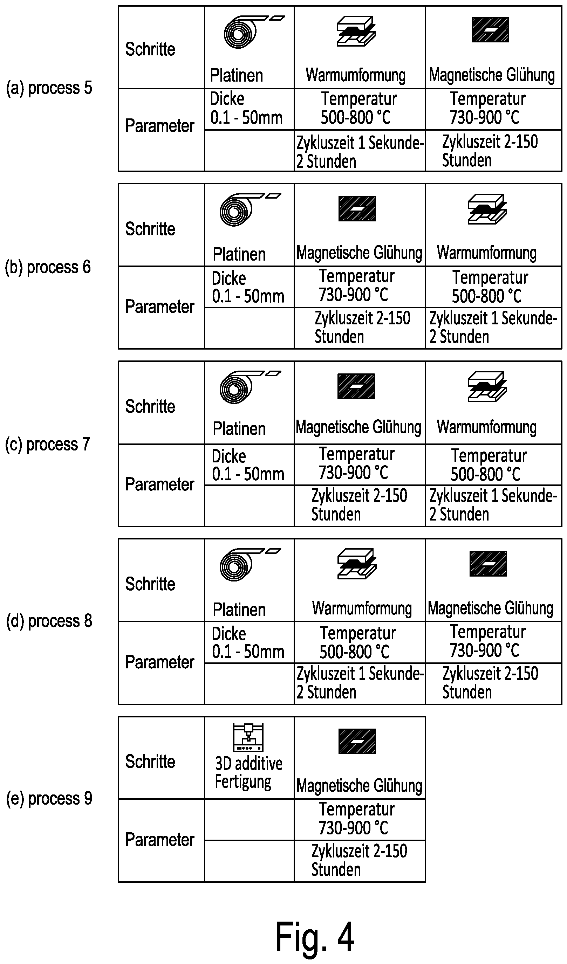

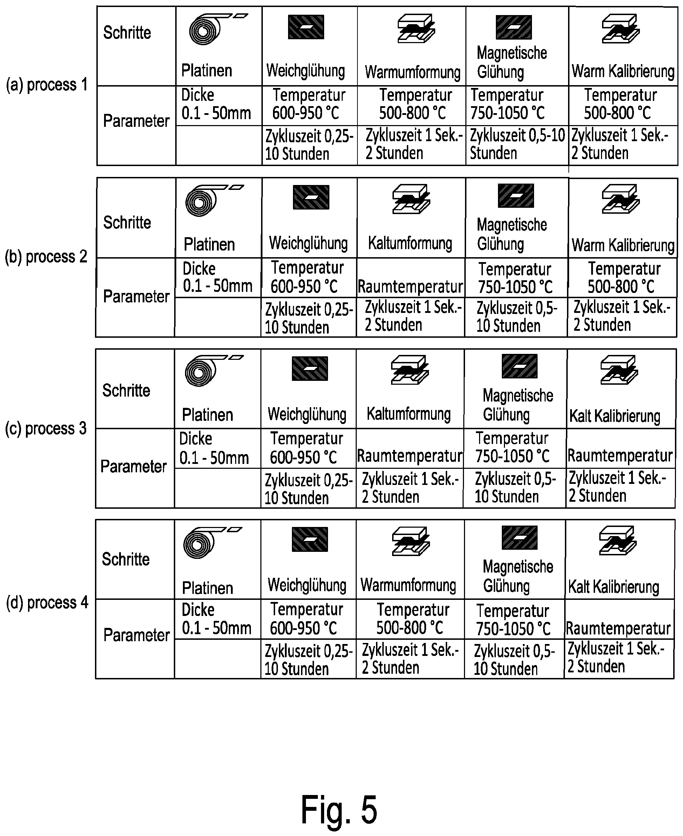

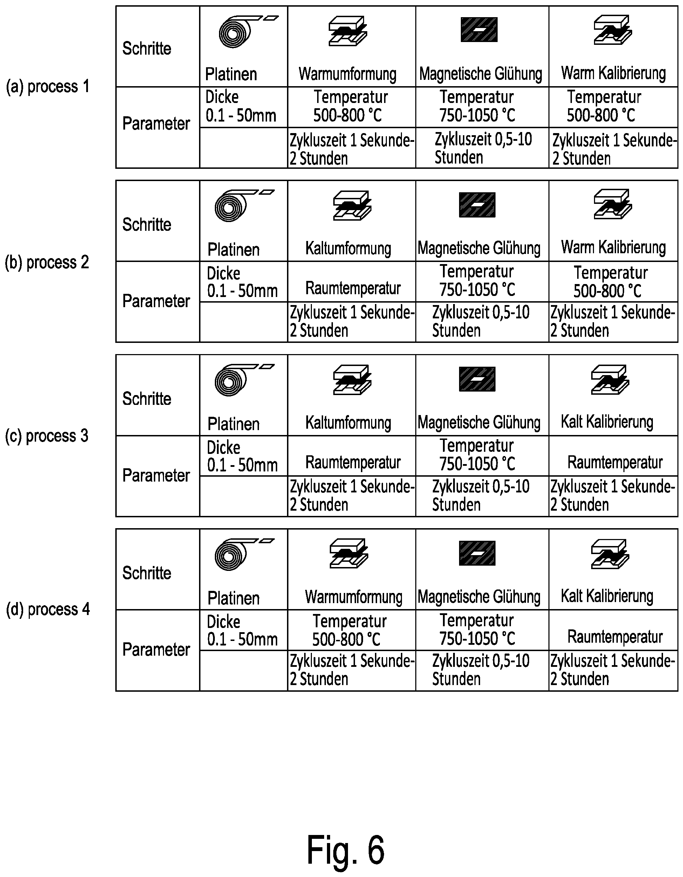

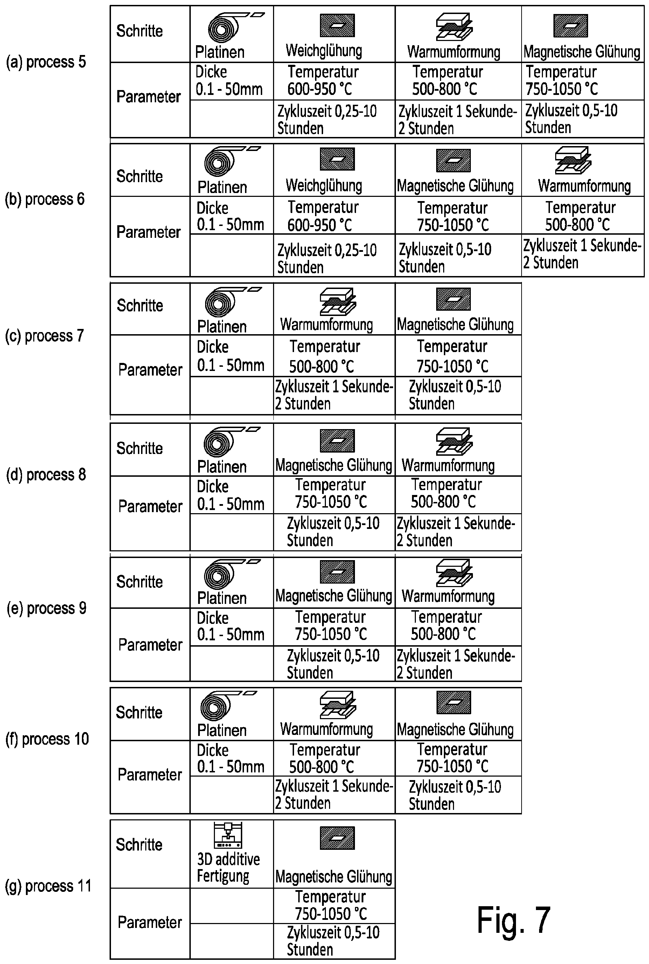

Die Figuren 3 bis 7 zeigen mögliche Herstellwege für andere Legierungszusammensetzungen. Hier zeigen Figuren 3 und 4 die mögliche Route für Kobalt-Eisen Legierungen und Figuren 5 bis 7 mögliche Wege für Silizium-Eisen Legierungen.

Bei der Erfindung ist von Vorteil, dass die Ausformung von monolithischen komplexen Bauteilen funktionale Vorteile hat gegenüber dem Stand der Technik, indem die Teile kaltgeformt und anschließend wärmebehandelt werden. Die Kombination des Wärmebehandlungsschrittes und der Warmumformung führt zu exakt geformten Bauteilen mit hoher magnetischer Abschirmwirkung. Die Warmumformung unter Beibehaltung der erforderlichen Temperaturen ermöglicht zudem komplexe Formgebung, welche insbesondere bei limitierten Bauräumen, zum Beispiel in der Elektromobilität, von Vorteil sind.

Mit der Erfindung gelingt es somit auch sehr komplexe Bauteile herzustellen. Solche Bauteile können dann auch zu komplexen Abschirmvorrichtungen kombiniert werden, beispielsweise zu ganzen Gehäusen, Verkleidungen, Kammern und dergleichen. Hierbei können die komplexen Bauteile oder Abschirmvorrichtungen auch aus unterschiedlichen Materialstärken ausgebildet sein. Ein Beispiel hierfür sind in der nachfolgenden Tabelle angegeben.

| Verwendung | Produktdicke | Ausqansmaterial |
|---|---|---|
| Abschirmung, Verkleidungen, Auskleidungen | 0.05 - 5.00 mm | Platinen, Metallpulver, Metalldraht |
| Kammern, Räume | 2 - 50 mm | Platinen, Metallpulver, Metalldraht |

Beispielsweise können aus einer weichgeglühten Nickel-Eisen-Legierung mit einem Gehalt von 48 Gew.-% Ni Platinen mit einer Länge von bis zu 3500 mm und einer Breite bis zu 2500 mm hergestellt werden und zu einer drei dimensionalen Abschirmung umgeformt werden. Als Fügeverfahren zur Herstellung derart großer Platinen können alle Schmelzschweißverfahren, bevorzugt das Laserschweißen eingesetzt werden.

Zur Überprüfung der Erfindung wurde aus 2 mm dicken Platinen aus einer Nickel-Eisen-Legierung mit einem Gehalt von 48 Gew.-% Ni mittels Kaltumformung, also Tiefziehen, bei Raumtemperatur eine sphärische Kuppel, Tiefe 50mm und Diameter 100mm, geformt. Diese Verformung verschlechtert die magnetischen Eigenschaften, daher würden dies von einem Fachmann nicht als magnetisches Abschirmelement verwendet werden. Derartige Teile werden verwendet um den Effekt der Erfindung darzustellen und daher als Referenzteile bezeichnet.

Dieser Prozess wurde für eine gleichmäßige Spannungs- und Dehnungsverteilung gewählt. Weitere Teile wurden mit dem gleichen Prozess auf eine Ziehtiefe von 48mm (und 100mm Durchmesser) geformt. Diese Teile sind Testteile zur Charakterisierung des Kalibrierungsprozesses und werden nach thermischer Behandlung auf 50mm fertig gezogen. Die magnetischen Eigenschaften der Test- und Referenzteile wurden vor der Wärmebehandlung charakterisiert.

Test- und Referenzteile wurden zusammen einem Magnetisierungsglühen bei 1150°C für eine Zeit von 4 Stunden unter Wasserstoffatmosphäre unterzogen. Nach dieser Prozessstufe sind die Referenzteile fertig (die Teile sind nach Figur 1 (c) gefertigt).

Die Testteile (48mm) wurden mittels Kaltumformung, also Tiefziehen bei Raumtemperatur auf eine Tiefe von 50mm und Durchmesser 100mm fertig gezogen diesem Schritt erfolgt eine Kalibrierung von 2mm (von 48mm nach 50m), was zu einer berechneten globalen Dehnung von ca. 4 % führt (die Teile sind nach das Prozess in Abbildung 1 (c) gefertigt). Zwischen dem Fertigzug und den nächsten Prozessschritten wurden die magnetischen Eigenschaft der Testteile nochmals charakterisiert. Diese Testteile wurden nach dem Fertigzug einem zweitem Magnetisierungsglühen bei 1150°C für eine Zeit von 4 Stunden unter Wasserstoffatmosphäre unterzogen und auf ihre magnetischen Eigenschaften getestet.

Die Charakterisierung zeigte, dass die magnetische Abschirmung nach dem Magnetisierungsglühen die besten Werte aufwies. Ohne Abschirmung wird eine magnetischer Fluss von 36.7 mT gemessen. Dieser Wert wird bei den Referenzteile nach Magnetisierungsglühen auf bis zu 58 µT (mit einem Reduzierungsfaktor von 633) abgesenkt, während an den Referenzteilen vor dem Glühen ein Wert von 1.8 mT gemessen wurde (dies entspricht einem Reduzierungsfaktor von 20). Das Glühen bietet eine mehr als 30 fache Verbesserung der Abschirmung im Vergleich zum nur kaltumgeformten Teil.

Bei den Testteilen mit einem kalten Kalibrierungsschritt (4% Dehnung), nach dem Magnetisierungsglühen wurde ein magnetischer Fluss von 418 µT gemessen (Reduzierungsfaktor 92). Mit diesem Ergebnis ist die Abschirmung hier ca. 4,5x besser als ohne Magnetisierungsglühen, aber ca. 6x schlechter als bei den geglühten Referenzteilen.

Diese Dehnung von 4% ist für einen Kalibrierungsschritt eine sehr hoher Wert und tritt in Realteilen bestenfalls sehr lokal auf. Dennoch konnten mit dem erfindungsgemäßen Verfahren gute Eigenschaften realisiert werden. Üblicherweise treten Verformungen in der Praxis nur in radiennahen freien Umformzonen ohne Stempelkontakt auf, womit große Bereiche weitgehend unverformt bleiben.

In einem weiteren Versuch wurde eine deutlich größere erfindungsgemäße magnetische Abschirmungen hergestellt und charakterisiert (ca. 600 x 300 x 80 mm). Aus einem weichgeglühten 48 Gew.-% Nickel-Eisen-Legierung-Blech mit 2 mm Dicke wurde in einem Umformschritt bei Raumtemperatur einen kuppelförmige Geometrie hergestellt und geometrisch charakterisiert.

Das Bauteil wurde einem Magnetisierungsglühen bei 1150°C für eine Zeit von 4 Stunden unter Wasserstoffatmosphäre unterzogen. Danach wurde eine magnetische- und geometrische Charakterisierung durchgeführt.. Die geometrische Messungen wiesen eine Abweichung von der Geometrie nach dem ersten Umformschritt von 1 % auf. Diese ist auf das Kriechen während des Magnetisierungsglühens zurückzuführen.

Um die Zielgeometrie wieder herzustellen, erfolgte ein Tiefzieh-Kalibrierprozess bei Raumtemperatur. Dabei trat eine lokale Dehnung von ca. 0.7 % in den Radien des Bauteils auf (die Teile sind entsprechend dem Prozess in Abbildung 1 (c) gefertigt).

Die magnetische Charakterisierung zeigt, dass, bei einer relativ hohen magnetische Flussdichte von 1.2 mT, die erfindungsgemäßen Produkte eine um 9 % geringere magnetische Abschirmung erreichen im Vergleich zu den geglühten Teilen vor der Kalibrierung. Bei einer niedrigeren Flussdichte von etwa 300 µT wurde kein Unterschied gemessen. Dies ist damit zu erklären, dass bei der niedrigeren Flussdichte keine (lokale) Sättigung auftritt.

Diese beiden Beispiele zeigen, dass das vorgestellte Verfahren mit Kalibrierungsschritt große lokale Auswirkungen auf die Permeabilität haben kann, aber global eine gut funktionierende Abschirmung erreichen kann. Darüber hinaus entspricht die Form bei diesem Verfahren der Sollgeometrie an den Testteile, wo an der Referenzteile eine Formabweichung durch Materialkriechen vorliegt. Mit einem Kalibrierungsschritt können sind äußerst exakte und komplexe Geometrien herstellbar, vorteilhaft bei bauraumbeschränkten oder miniaturisierten Anwendungen.

## Patentansprüche

1. Verfahren zum Herstellen dreidimensionaler magnetischer Abschirmungen mit einer ausreichenden Permeabilität aus ungeglühten, weichgeglühten oder magnetisch geglühten weichmagnetischen Metallblechen, wobei das Metallblech
entweder
in einem ein- oder mehrstufigen Prozess zu dem dreidimensionalen Bauteil kalt umgeformt wird, anschließend einer (magnetischen) Glühung zur Erhöhung der Permeabilität unterzogen und dann in ein Formwerkzeug überführt wird, indem es im heißen Zustand oder auf Raumtemperatur in einem Werkzeug gehalten und/oder gepresst wird, welches die Sollkontur des Bauteils besitzt und durch das Werkzeug gegebenenfalls formkorrigiert oder kalibriert wird und, in dem Werkzeug abkühlen gelassen wird,
oder
ein Blech zum Zwecke der Umformung und der Erhöhung Permeabilität erhitzt wird und anschließend in einem Warmumformwerkzeug auf die Sollgeometrie umgeformt wird und gehalten wird und in dem Werkzeug abkühlen gelassen wird.

2. Verfahren nach Anspruch 1, **dadurch gekennzeichnet, dass** als weichmagnetisches Metallblech Blech aus einer aus einer magnetisierbaren Nickel-Eisen-Legierung, einer magnetisierbaren Silizium-Eisen-Legierung, einer magnetisierbaren Kobalt-Eisen-Legierung oder anderen magnetisierbaren Metalllegierungen verwendet wird.

3. Verfahren nach Anspruch 1, **dadurch gekennzeichnet, dass** das Blech vor der kalten Umformung oder nach der kalten Umformung oder das Blech vor der warmen Umformung einer Weichglühung unterzogen wird.

4. Verfahren nach einem der vorhergehenden Ansprüche, **dadurch gekennzeichnet, dass** bei einer Nickel-Eisen-Legierung das Weichglühen bei 600 bis 900°C, insbesondere bis 700 bis 800°C durchgeführt wird.

5. Verfahren nach einem der vorhergehenden Ansprüche, **dadurch gekennzeichnet, dass** bei einer Nickel-Eisen-Legierung das magnetische Glühen bei 1000 bis 1400°C, insbesondere 1100 bis 1300°C, insbesondere bei 1150°C durchgeführt wird.

6. Verfahren nach einem der vorhergehenden Ansprüche, **dadurch gekennzeichnet, dass** bei einer Nickel-Eisen-Legierung die Warmumformung bei 500 bis 800°C, insbesondere 600 bis 800°C, bevorzugt 600°C durchgeführt wird.

7. Verfahren nach einem der vorhergehenden Ansprüche, **dadurch gekennzeichnet, dass** bei einer Nickel-Eisen-Legierung das Warmkalibrieren bei 500 bis 800°C, insbesondere 600 bis 800°C, bevorzugt 600°C durchgeführt wird.

8. Verfahren nach einem der Ansprüche 1 bis 3, **dadurch gekennzeichnet, dass** bei einer Kobalt-Eisen-Legierung das magnetische Glühen bei 700 bis 950°C, insbesondere 730 bis 900°C durchgeführt wird.

9. Verfahren nach einem der vorhergehenden Ansprüche, **dadurch gekennzeichnet, dass** bei einer Kobalt-Eisen-Legierung die Warmumformung bei 500 bis 800°C, insbesondere 600 bis 800°C, durchgeführt wird.

10. Verfahren nach einem der vorhergehenden Ansprüche, **dadurch gekennzeichnet, dass** bei einer Kobalt-Eisen-Legierung das Warmkalibrieren bei 500 bis 800°C, insbesondere 600 bis 800°C, durchgeführt wird.

11. Verfahren nach einem der vorhergehenden Ansprüche, **dadurch gekennzeichnet, dass** bei einer Silizium-Eisen-Legierung das Weichglühen bei 600 bis 950°C, insbesondere bis 700 bis 800°C durchgeführt wird.

12. Verfahren nach einem der vorhergehenden Ansprüche, **dadurch gekennzeichnet, dass** bei einer Silizium-Eisen-Legierung das magnetische Glühen bei 700 bis 1100°C, insbesondere 750 bis 1050°C durchgeführt wird.

13. Verfahren nach einem der vorhergehenden Ansprüche, **dadurch gekennzeichnet, dass** bei einer Silizium-Eisen-Legierung, die Warmumformung bei 500 bis 800°C, insbesondere 600 bis 800°C durchgeführt wird

14. Verfahren nach einem der vorhergehenden Ansprüche, **dadurch gekennzeichnet, dass** bei einer Silizium-Eisen-Legierung das Warmkalibrieren bei 500 bis 800°C, insbesondere 600 bis 800°C durchgeführt wird

15. Verfahren nach einem der Ansprüche 2 bis 7, **dadurch gekennzeichnet, dass** die Zykluszeit bei Nickel-Eisen-Legierungen bei einem Weichglühen 2 bis 10h, bei einem magnetischen Glühen 2 bis 150h, bei einem Warmumformen 1 sek. bis 2h, bei einem Warmkalibrieren 1 sek. bis 2h, bei einem Kaltumformen 1 sek. bis 2h und bei einem Kaltkalibrieren 1 sek. bis 2h beträgt.

16. Verfahren nach einem der Ansprüche 2 und 8 bis 10, **dadurch gekennzeichnet, dass** die Zykluszeit bei Kobalt-Eisen-Legierungen bei einem magnetischen Glühen 2 bis 150h, bei einem Warmumformen 1 sek. bis 2h , bei einem Warmkalibrieren 1 sek. bis 2h, bei einem Kaltumformen 1 sek. bis 2h und/bei einem Kaltkalibrieren 1 sek. bis 2h beträgt.

17. Verfahren nach einem der Ansprüche 2 und 11 bis 14, **dadurch gekennzeichnet, dass** die Zykluszeit bei Silizium-Eisen-Legierungen bei einem Weichglühen 0,25 bis 10h, bei einem magnetischen Glühen 0,5 bis 10h, bei einem Warmumformen 1 sek. bis 2h, bei einem Warmkalibrieren 1 sek. bis 2h, bei einem Kaltumformen 1 sek. bis 2h und bei einem Kaltkalibrieren 1 sek. bis 2h beträgt.

18. Verfahren nach einem der vorhergehenden Ansprüche, **dadurch gekennzeichnet, dass** die Umformgeschwindigkeit, insbesondere beim Warmumformen bevorzugt zwischen 5 mm/min und 60 mm/min Werkzeuggeschwindigkeit beträgt.

19. Verfahren nach einem der vorhergehenden Ansprüche, **dadurch gekennzeichnet, dass** das Bauteil nach dem Warmumformen oder nach dem Halten im Werkzeug bei einer Temperatur entnommen wird, bei der das Bauteil gegen Materialfließen stabil ist und an Luft abkühlen kann und insbesondere bei 200 bis 600°C, insbesondere 300 bis 500°C entnommen wird.

20. Verfahren nach einem der vorhergehenden Ansprüche, **dadurch gekennzeichnet, dass** das Blech mittels Schweißungen aus mehreren Platinen hergestellt wird, insbesondere Kombinationen von mehreren Platinen aus verschieden Legierungen, Dicken oder Anlassgraden oder Glühgraden, insbesondere bezüglich eines Weich-, Lösungs- und/oder Spannungsarmglühen.

21. Verfahren nach Anspruch 20, **dadurch gekennzeichnet, dass** die geschweißten Platinen eben oder dreidimensional ausgeformte Bauteile sind, die vor, innerhalb oder nach dem Prozess miteinander verschweißt werden.

22. Abschirmvorrichtung aus einem dreidimensionalen ausgebildeten Metallblech einer hohen Permeabilität oder zusammengesetzt aus einer Mehrzahl von Metallblechen, insbesondere hergestellt nach einem Verfahren nach einem der vorhergehenden Ansprüche, wobei das Metallblech entweder
in einem ein- oder mehrstufigen Prozess zu dem dreidimensionalen Bauteil kalt umgeformt ist, anschließend einer (magnetischen) Glühung zur Erhöhung der Permeabilität unterzogen und dann in ein Formwerkzeug überführt wird, indem es im heißen Zustand oder auf Raumtemperatur in einem Werkzeug gehalten und/oder gepresst ist, welches die Sollkontur des Bauteils besitzt und durch das Werkzeug gegebenenfalls formkorrigiert oder kalibriert wird und, in dem Werkzeug abkühlen gelassen wird,
oder
ein Blech zum Zwecke der Umformung und der Erhöhung Permeabilität erhitzt ist und anschließend in einem Warmumformwerkzeug auf die Sollgeometrie umgeformt ist und gehalten wird und in dem Werkzeug abkühlen gelassen ist.

23. Abschirmvorrichtung nach Anspruch 22, **dadurch gekennzeichnet, dass** das Metallblech aus einer magnetisierbaren Nickel-Eisen-Legierung, einer magnetisierbaren Silizium-Eisen-Legierung, einer magnetisierbaren Kobalt-Eisen-Legierung oder anderen magnetisierbaren Metalllegierungen besteht.

24. Abschirmvorrichtung nach Anspruch 22 oder 23, **dadurch gekennzeichnet, dass** bei Nickel-Eisen-Legierungen der Nickel-Gehalt zwischen 30 und 90 Gew.-% beträgt, wobei der Nickel Gehalt insbesondere zwischen 50-80 Gew.-% beträgt, wobei die Nickel-Eisen-Legierung weitere Elemente wie Molybdän und/oder Chrom im Bereich von bis zu 10 Gew.-% umfassen kann und weitere Elemente wie Mangan, Silizium und/oder Kohlenstoff im Bereich von jeweils bis zu 1 Gew.-% umfassen kann und der Rest aus Eisen und unvermeidbare Verunreinigungen besteht..

25. Abschirmvorrichtung nach Anspruch 23, **dadurch gekennzeichnet, dass** bei einer Silizium-Eisen-Legierungen der Silizium-Gehalt zwischen 0,1-8 Gew.-% beträgt wobei die Silizium-Eisen-Legierung Mangan bis zu 1 Gew.-% und Aluminium bis 2 Gew.-% enthalten kann und der Rest aus Eisen und unvermeidbare Verunreinigungen besteht.

26. Abschirmvorrichtung nach Anspruch 23, **dadurch gekennzeichnet, dass** Bei Kobalt-Eisen-Legierungen der Kobalt-Gehalt 9-60 Gew.-% bevorzugt 10-27 Gew.-% beträgt, wobei die Kobalt-Eisen-Legierung Chrom von 2 bis 10 Gew.-% enthalten kann und Molybdän, Vanadium, Niob, Tantal, Aluminium, Zirkonium und/oder Mangan im Bereich von jeweils bis zu 2 Gew.-% und in Summe bis zu 5 Gew.-% enthalten sein können und der Rest aus Eisen und unvermeidbaren Verunreinigungen besteht.

27. Verwendung einer Abschirmvorrichtung nach einem der Ansprüche 22 bis 26 für Verkleidungen, Auskleidungen und Abschirmungen aus einzelnen Blechen oder komplexen Abschirmbauteilen aus mehreren zusammengesetzten Blechen.

28. Verwendung einer Abschirmvorrichtung nach einem der Ansprüche 22 bis 26 für die Ausbildung von Gehäusen, Kammern, Räumen und dergleichen.
